Europäisches Patentamt

European Patent Office

Office européen des brevets

(11) Publication number: **0 218 333 B1**

## EUROPEAN PATENT SPECIFICATION

(45) Date of publication of patent specification :
27.02.91 Bulletin 91/09

(51) Int. Cl.⁵ : **H03F 1/30**

(21) Application number : **86306254.3**

(22) Date of filing : **13.08.86**

(54) Bias circuit for fet.

(30) Priority : **13.08.85 JP 178943/85**

(43) Date of publication of application :
**15.04.87 Bulletin 87/16**

(45) Publication of the grant of the patent :
**27.02.91 Bulletin 91/09**

(84) Designated Contracting States :
**DE GB NL SE**

(56) References cited :
**DE-A- 2 417 994**
**DE-A- 2 550 636**
**DE-A- 2 613 937**
**DE-A- 3 017 654**
**US-A- 3 875 430**

(73) Proprietor : **NEC CORPORATION**
**7-1, Shiba 5-chome Minato-ku**
**Tokyo 108-01 (JP)**

(72) Inventor : **Asazawa, Hiroshi**
**c/o NEC Corporation 33-1 Shiba 5-chome**
**Minato-ku Tokyo (JP)**
Inventor : **Hashimoto, Kazuya**
**c/o NEC Corporation 33-1 Shiba 5-chome**
**Minato-ku Tokyo (JP)**

(74) Representative : **Pears, David Ashley et al**
**REDDIE & GROSE 16 Theobalds Road**
**London WC1X 8PL (GB)**

## Description

The present invention relates to a bias circuit for a transistor and, more particularly, to a bias circuit which is provided means for compensating for deviations in the threshold voltage of a field effect transistor (FET).

A prior art bias circuit for an FET comprises a voltage dividing resistor which applies a gate bias to the FET. The problem with this type of bias circuit is that the voltage dividing resistor does not compensate for scattering of the threshold voltage $V_T$ of the FET.

Another prior art bias circuit for FET is disclosed in the paper entitled "Broadband GaAs Monolithic Amplifier" and presented by Onoda et al at the 1984 National Meeting of the Institute of Electronics and Communication Engineers of Japan, April 1984. The bias circuit proposed by Onoda et al is constructed to shift the operating point of an FET by a negative feedback circuit so that scattering of the threshold value $V_T$ may be compensated for. However, the compensation attainable with such a bias circuit is not satisfactory.

It is therefore an object of the present invention to provide a new bias circuit which confines errors in operating current to a narrow range over a wide range of threshold voltages $V_T$ and is feasible for installation in an integrated circuit.

In accordance with the present invention, there is provided a bias circuit for the compensation of threshold voltage variation on a first FET comprising a resistor connected between two power supply terminals and having a first tap which is connected to a gate of the first FET, a second FET having its drain connected to a second tap point of the resistor and its gate and source connected to reference potential points, the two FETS being fabricated by the same processing steps but being of different sizes, such that compensation of the threshold voltage variation by the second FET takes place. The first and second taps, also referred to below as division points, may be coincident or separated from each other.

The invention further provides a method of controlling the operating current of an FET as defined in claim 8.

DE-A 2 417 994 already discloses a circuit for temperature compensation in which the gate bias on a load FET is determined by a potential divider formed by a resistor in series with a second FET fabricated by the same processing steps as the load FET, thus compensation for differences in electrical characteristics. The gate and source of the second FET are connected to reference potentials. The drain is connected to the resistor and to the gate of the load FET. The relative sizes of the FETs are not considered. In another embodiment the second FET is replaced by the parallel combination of enhancement and depletion type FETs with the gate of the enhancement type FET connected to a different reference potential (the end of the resistor remote from the gate of the load FET).

The invention will be described in more detail, by way of example, with reference to the accompanying drawings, in which :

Figs. 1 to 4 are schematic diagrams of first to fourth embodiments of a bias circuit for an FET in accordance with the present invention ;

Figs. 5 and 6 are graphs showing characteristics of a bias circuit of the present invention together with those of a prior art circuit which is shown in Fig. 7 ; and

Fig. 7 is a schematic diagram of the prior art bias circuit for an FET.

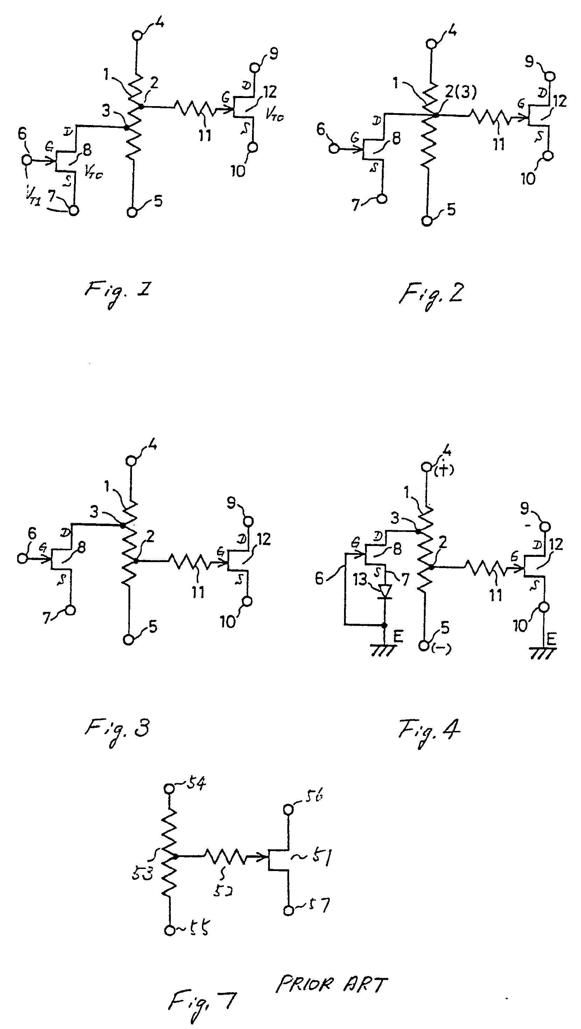

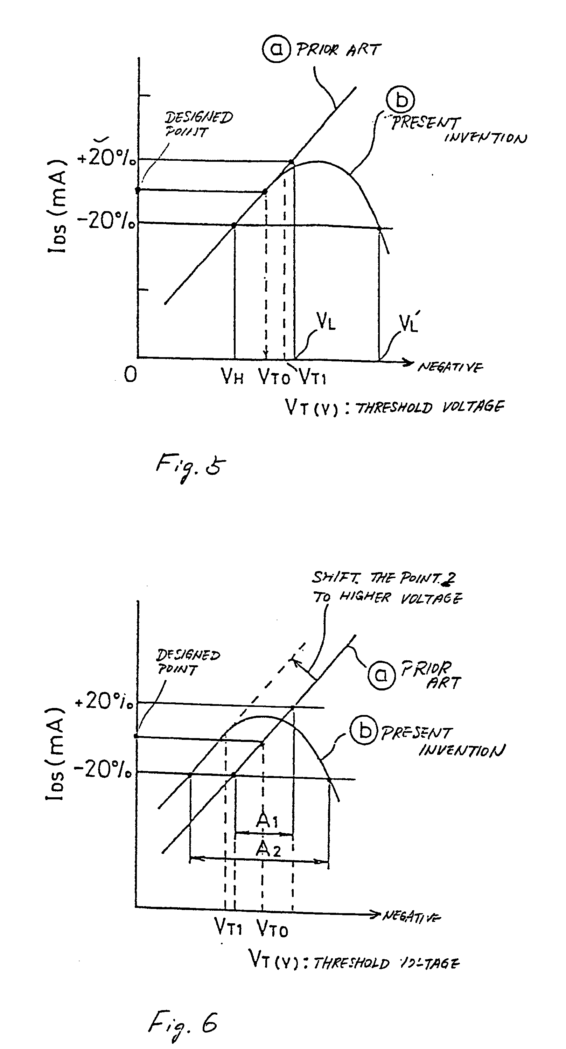

To better understand the present invention, a brief reference will be made to a prior art bias circuit for an FET, shown in Fig. 7. As shown, a resistor 53 which is connected to power supply terminals 54 and 55 supplies a bias voltage to a gate of an FET 51 via a resistor 52. As previously stated, this kind of arrangement is disadvantageous in that because the bias voltage, or voltage divided by the resistor 53, is constant, any deviation in the threshold voltage $V_T$ of the FET results in a deviation in the operating point of the FET. In Fig. 7, the reference numerals 56 and 57 respectively designate power supply terminals for the FET 51.

Referring to Fig. 1, a first embodiment of the bias circuit in accordance with the present invention is shown. An FET 12 is shown as having a drain and a source connected to power supply terminals 9 and 10, respectively, and a gate connected to one end of a resistor 11. Those elements which are designated by the reference numerals 1 to 8 constitute the bias circuit which biases the FET 12. Specifically, a resistor 1 which is connected to power supply terminals 4 and 5 is divided at a point of division 2 so that a gate bias is applied to the FET 12 via the resistor 11. So far as such a system is concerned, this embodiment is the same as the prior art bias circuit of Fig. 7. A characteristic feature of this particular embodiment is an FET 8 which has a drain connected to another point of division 3 of the resistor 1, and a gate and a source connected to power supply terminals 6 and 7, respectively. It is important to note that the FET 8 is different in size from the FET 12 but fabricated at the same process step as the FET 12 and is equal in threshold voltage $V_T$ to the FET 12.

The division points 2 and 3 of the resistor 1 may have any of three different relative positions, i.e., a position of Fig. 1 wherein the division point 2 has a higher potential than the division point 3, a position of Fig. 2 wherein the division points 2 and 3 have the same potentials, and a position of Fig. 3 wherein the division point 3 has a higher potential than the division point 2. The division point 2 is determined by potentials at the power supply terminals 4, 5 and 10 and a predetermined voltage across the gate and source of the FET 12. However, the division point 3 is open to choice so long as it remains higher in potential than the power supply terminal 7 and ensures a voltage across the drain and source of the FET 8. These are the reasons which account for the three alternative connections as shown in Figs. 1 to 3. Because all of the three connections share the same operation principle, the following description will concentrate on the connection of Fig. 1 by way of example.

In Fig. 1, the voltage across the power supply terminals 6 and 7 is so set up to have a threshold value $V_{T1}$. Assuming that the designed threshold voltage of the FETs 8 and 12 is $V_{T0}$, the following relationship is set up :

$$V_{T1} < V_{T0} < 0$$

When the threshold value $V_T$ of an actually manufactured FET is greater than the threshold value $V_{T1}$, the FET 8 remains turned off so that the voltage at the terminal 2 is equal to the divided voltage. As the threshold value $V_T$ becomes equal to or smaller than the threshold value $V_{T1}$, the FET 8 is turned on to cause a current to flow with the result that the voltage at the terminal 3 is lowered due to the resultant voltage drop. This lowers the voltage at the terminal (division point) 2 which is applied to the gate of the FET 12. Further, when the threshold value $V_T$ is equal to or smaller than the threshold value $V_{T1}$ and the latter is smaller than the threshold value $V_{T0}$, the FET current $I_{DS}$ becomes greater than in the case with the threshold value $V_{T0}$. But, the voltage at the terminal (division point) 2 is lowered to shift the current $I_{DS}$ to a lower side. Therefore, the degree of deviation of the current can be reduced, compared to the prior art system of Fig. 7.

By adequately selecting the size of the FET 8, it is possible to provide a bias circuit which compensates for scattering of the threshold voltage $V_T$, as represented by a graph of Fig. 5. In Fig. 5, the abscissa is indicative of threshold voltages $V_T$ of the FETs 8 and 12 and the ordinate, the drain-source current $I_{DS}$ of the FET 12. Assuming that the allowable range of current values is ±20 percent, while the range of threshold voltages $V_T$ attainable with the prior art circuit of Fig. 7 is limited to $V_L < V_T < V_H$ as represented by a characteristic ⓐ, that of the present invention is as wide as $V_L\cdot < V_T < V_H$ as represented by a characteristic ⓑ. Further, in the circuit of Fig. 1 if $V_{T1}$ is greater than $V_{T0}$ and the division point 2 is selected to be higher in potential than that of Fig. 7, the maximum value can be shifted to the vicinity of $V_T \fallingdotseq V_{T0}$ as represented by a characteristic ⓑ of Fig. 6, so that a bias circuit which compensates for the threshold voltage scattering in both the cases of $V_T < V_{T0}$ and $V_T > V_{T0}$ is achievable. That is, the allowable range of $V_T$ deviation is extended from $A_1$ to $A_2$, as shown in Fig. 6.

Referring to Fig. 4, a more specific embodiment of the present invention is shown. The bias circuit of Fig. 4 is applicable to an FET whose threshold voltage $V_T$ is nearly equal to −1 volt. As shown, the bias circuit includes a positive power supply terminal 4, a negative power supply terminal 5 and a ground terminal E. The bias circuit is constructed such that when the threshold voltage $V_T$ of the FET 12 has been lowered beyond the order of 0.7 volt, a diode 13 turns on the FET 8. The operation principle of this embodiment is the same as that of Fig. 1.

In summary, it will be seen that in accordance with the present invention an extra FET adapted to compensate for variations of threshold voltage $V_T$ is added to an ordinary resistance-division type bias circuit, so that errors of operating current of an FET are confined in a narrow range over a wide range of threshold values $V_T$. In addition, the bias circuit of the present invention can be fabricated at the same process step as an FET and a resistor and, hence, it is optimum not only as a bias circuit of a single FET but also as a bias circuit which is to be built in an integrated circuit chip.

## Claims

1. A bias circuit for the compensation of threshold voltage variation in a first FET (12) comprising a resistor (1) connected between two power supply terminals (4, 5) and having a first tap (2) which is connected to a gate of the first FET (12), a second FET (8) having its drain connected to a second tap point (3) of the resistor (1) and its gate and source connected to reference potential points (6, 7) the two FETS (12, 8) being fabricated by the same processing steps but being of different sizes, such that compensation of the threshold voltage variation by the second FET (8) takes place.

2. A bias circuit as claimed in claim 1, characterised in that the potentials at the first and second taps (2, 3) are different from each other.

3. A bias circuit as claimed in claim 2, characterised in that the potential at the first tap (2) is higher than the potential at the second tap (3).

4. A bias circuit as claimed in claim 2, characterised in that the potential at the first tap (2) is lower than the potential at the second tap (3).

5. A bias circuit as claimed in claim 1, characterised in that the potentials at the first and second taps (2, 3) are equal to each other.

6. A bias circuit as claimed in any of claims 1 to 5, characterised in that the reference potential on the gate of the second FET (8) is ground potential, the bias circuit further comprising a diode (13) which has its anode connected to the source of the second FET (8) and its cathode connected to the ground potential.

7. A bias circuit as claimed in any of claims 1 to 6, characterised by a gate resistor (11) connected between the first tap (2) and the gate of the first FET (12).

8. A method of controlling the operating current of a first FET (12), by applying a bias voltage to a gate of the FET (12) from a tap (2) of a resistor (1) which is connected between two power supply terminals (4, 5) wherein the current which flows through the resistor (1) is controlled by a second FET (8) which is fabricated by the same processing steps as the first FET (12) and has its drain connected to a tap (3) of the resistor (1) and its gate and source connected to reference potentials, the size of the second FET (8) being adjusted relative to that of the first FET (12).

## Ansprüche

1. Vorspannungsschaltkreis zur Kompensation einer Schwellenspannungsveränderung in einem ersten FET (12), mit einem Widerstand (1), der zwischen zwei Stromversorgungsanschlüssen (4, 5) angeschlossen ist und einen ersten Abgriff (2) aufweist, der mit einem Gate des ersten FET (12) verbunden ist, einem zweiten FET (8), dessen Drain mit einem zweiten Abgriff (3) des Widerstandes (1) verbunden ist und dessen Gate und Source mit Referenzpotentialanschlüssen (6, 7) verbunden sind, wobei die zwei FETs (12, 8) durch dieselben Prozeßschritte hergestellt wurden, aber eine unterschiedliche Größe aufweisen, so daß die Kompensation der Schwellenspannungsveränderung durch den zweiten FET (8) ausgeführt wird.

2. Vorspannungsschaltkreis nach Anspruch 1, dadurch gekennzeichnet, daß die Potentiale an den ersten und zweiten Abgriffen (2, 3) unterschiedlich voneinander sind.

3. Vorspannungsschaltkreis nach Anspruch 2, dadurch gekennzeichnet, daß das Potential am ersten Abgriff (2) höher als das Potential am zweiten Abgriff (3) ist.

4. Vorspannungsschaltkreis nach Anspruch 2, dadurch gekennzeichnet, daß das Potential am ersten Abgriff (2) niedriger als das Potential am zweiten Abgriff (3) ist.

5. Vorspannungsschaltkreis nach Anspruch 1, dadurch gekennzeichnet, daß die Potentiale an den ersten und zweiten Abgriffen (2, 3) gleich sind.

6. Vorspannungsschaltkreis nach einem der Ansprüche 1 bis 5, dadurch gekennzeichnet, daß das Referenzpotential auf dem Gate des zweiten FET (8) das Erdpotential ist, wobei der Vorspannungsschaltkreis ferner eine Diode (13) aufweist, dessen Anode mit dem Source des zweiten FET (8) und dessen Kathode mit dem Erdpotential verbunden ist.

7. Vorspannungsschaltkreis nach einem der Ansprüche 1 bis 6, gekennzeichnet durch einen Gatewiderstand (11), der zwischen dem ersten Abgriff (2) und dem Gate des ersten FET (12) angeschlossen ist.

8. Verfahren zum Steuern des Arbeitsstromes eines ersten FET (12) durch Anlegen einer Vorspannung an das eine Gate des FET (12) von einem Abgriff (2) eines Widerstandes (1), der zwischen den zwei Stromversorgungsanschlüssen (4, 5) angeschlossen ist, wobei der Strom, der durch den Widerstand (1) fließt, durch einen zweiten FET (8) gesteuert wird, der durch dieselben Prozeßschritte wie der erste FET (12) hergestellt wird und dessen Drain mit einem Abgriff (3) des Widerstandes (1) und dessen Gate und Source mit den Referenzpotentialen verbunden sind, wobei die Größe des zweiten FETs (8) relativ zu der des ersten FET (12) eingestellt wird.

## Revendications

1. Circuit de polarisation pour la compensation de la variation de la tension de seuil dans un premier transistor à effet de champ FET (12) comprenant une résistance (1) montée entre deux bornes (4, 5) d'une alimentation et ayant une première prise (2) qui est connectée à une grille du premier FET (12), un second FET (8) ayant son drain relié à un second point de prise (3) de la résistance (1) et ses grille et source connectées à des points d'un potentiel de référence (6, 7), les deux FETS (12, 8) étant fabriqués par les mêmes étapes de procédé mais étant de dimensions différentes, de sorte qu'a lieu la compensation de la variation de la tension de seuil par le second FET (8).

2. Circuit de polarisation selon la revendication 1, caractérisé en ce que les potentiels aux première et seconde prise (2, 3) sont différents l'un de l'autre.

3. Circuit de polarisation selon la revendication 2, caractérisé en ce que le potentiel à la première prise (2) est supérieur au potentiel à la seconde prise (3).

4. Circuit de polarisation selon la revendication 2, caractérisé en ce que le potentiel à la première prise (2) est inférieur au potentiel à la seconde prise (3).

5. Circuit de polarisation selon la revendication 1, caractérisé en ce que les potentiels aux première et seconde prises (2, 3) sont égaux l'un à l'autre.

6. Circuit de polarisation selon l'une quelconque des revendications 1 à 5, caractérisé en ce que le potentiel de référence appliqué à la grille du second FET (8) est le potentiel de la masse, le circuit de polarisation comprenant en outre une diode (13) dont l'anode est connectée à la source du second FET (8) et la cathode au potentiel de la masse.

7. Circuit de polarisation selon l'une quelconque des revendications 1 à 6, caractérisé par une résistance (11) de grille montée entre la première prise (2) et la grille du premier FET (12).

8. Procédé de commande du courant de fonctionnement d'un premier FET (12), par application d'une tension de polarisation à une grille du FET (12) à partir d'une prise (2) d'une résistance (1) qui est montée entre deux bornes (4, 5) d'une alimentation, où le courant qui traverse la résistance (1) est commandé par un second FET (8) qui est fabriqué par les mêmes étapes de procédé que le premier FET (12) et a son drain connecté à une prise (3) de la résistance (1) et ses grille et source reliées à des potentiels de référence, les dimensions du second FET (8) étant ajustées par rapport à celles du premier FET (12).

Fig. 1

Fig. 2

Fig. 3

Fig. 4

Fig. 7          PRIOR ART

Ⓐ PRIOR ART

Ⓑ PRESENT INVENTION

DESIGNED POINT

$+20\%$

$I_{DS}$ (mA)

$-20\%$

$V_L$

$V_L'$

$0$    $V_H$   $V_{TO}$ $V_{T1}$     NEGATIVE

$V_T$ (v): THRESHOLD VOLTAGE

Fig. 5

SHIFT THE POINT 2 TO HIGHER VOLTAGE

DESIGNED POINT

$+20\%$

$I_{DS}$ (mA)

$-20\%$

Ⓐ PRIOR ART

Ⓑ PRESENT INVENTION

$A_1$

$A_2$

$V_{T1}$ $V_{TO}$     NEGATIVE

$V_T$ (v): THRESHOLD VOLTAGE

Fig. 6